(19) Europäisches Patentamt
European Patent Office
Office européen des brevets

(11) **EP 2 208 561 A1**

## (12) EUROPEAN PATENT APPLICATION
published in accordance with Art. 153(4) EPC

(43) Date of publication:
**21.07.2010 Bulletin 2010/29**

(21) Application number: **08839620.5**

(22) Date of filing: **08.10.2008**

(51) Int Cl.:
**B23B 27/14** (2006.01)   **B23B 51/00** (2006.01)
**B23C 5/16** (2006.01)   **C23C 16/30** (2006.01)

(86) International application number:
**PCT/JP2008/068277**

(87) International publication number:
**WO 2009/051046 (23.04.2009 Gazette 2009/17)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **15.10.2007 JP 2007268032**

(71) Applicant: **Sumitomo Electric Hardmetal Corp.**
**Itami-shi**
**Hyogo 664-0016 (JP)**

(72) Inventors:
• **IMAMURA, Shinya**
**Itami-shi**
**Hyogo 664-0016 (JP)**

• **OMORI, Naoya**
**Itami-shi**
**Hyogo 664-0016 (JP)**
• **OKADA, Yoshio**
**Itami-shi**
**Hyogo 664-0016 (JP)**
• **KOJIMA, Chikako**
**Itami-shi**
**Hyogo 664-0016 (JP)**
• **OKUNO, Susumu**
**Itami-shi**
**Hyogo 664-0016 (JP)**

(74) Representative: **Grünecker, Kinkeldey, Stockmair & Schwanhäusser**
**Anwaltssozietät**
**Leopoldstrasse 4**
**80802 München (DE)**

## (54) EDGE REPLACEMENT-TYPE CUTTING CHIP

(57) An indexable insert according to the present invention includes a substrate and a coating layer formed on the substrate, the coating layer is formed of a plurality of layers including at least a TiCN layer, at least one of the plurality of layers is provided with compressive residual stress, the TiCN layer is mainly composed of TiCN and has highest peak intensity in a (422) plane and second peak intensity in a (311) plane in X-ray diffraction, and a ratio of peak intensity I(422)/I(311) between peak intensity I(422) of the (422) plane and peak intensity I(311) of the (311) plane is not lower than 1.1 and not higher than 10.

EP 2 208 561 A1

## Description

TECHNICAL FIELD

The present invention relates to an indexable insert.

BACKGROUND ART

An indexable insert removably attached to a tool for cutting a work material has conventionally been known. A large number of such indexable inserts, in which a hard coating film made of ceramics or the like is formed as a coating layer on a substrate composed of cemented carbide or cermet with a chemical vapor deposition method or a physical vapor deposition method in order to improve wear resistance or toughness, have been proposed.
In general, it has also been known that, due to a difference in coefficient of thermal expansion between the coating layer formed with the chemical vapor deposition method and the substrate, tensile residual stress originating from thermal stress after coating is present in the coating layer, which causes lower chipping resistance.
In order to address this, Japanese Patent Laying-Open No. 07-100701 (Patent Document 1) and Japanese Patent Laying-Open No. 11-256336 (Patent Document 2) disclose a coated cutting tool achieving excellent chipping resistance by controlling crystal orientation of a TiCN layer known as one of such coating layers. On the other hand, sufficient chipping resistance cannot be obtained simply by controlling crystal orientation of the coating layer, because tensile residual stress is present.
Meanwhile, Japanese Patent Laying-Open No. 04-300104 (Patent Document 3) discloses a surface-coated cutting tool achieving improved chipping resistance by performing shot peening after a coating layer is formed with the chemical vapor deposition method or a physical vapor deposition method, in which balls made of alumina are caused to collide with the coating layer by using compressed air such that the coating layer has tensile residual stress or compressive residual stress not higher than 9 kgf/mm$^2$ (88 MPa). Such a stress level is not sufficient as chipping resistance during high-efficiency working that has significantly improved in recent years, and further compressive residual stress should be provided.
In addition, Japanese Patent Laying-Open No. 64-031972 (Patent Document 4) discloses a high-toughness coating material for providing compressive stress not lower than 50 kgf/mm$^2$ (490 MPa) to a substrate and/or a coating film by performing shot peening with impact force as strong as possible on the coating film formed with the chemical vapor deposition method. If high compressive stress is present over the entire coating film, however, the coating film itself self-destructs, which results in lower wear resistance. Moreover, as adhesiveness between the coating film and the substrate becomes poorer, the coating film tends to peel off.

Patent Document 1: Japanese Patent Laying-Open No. 07-100701
Patent Document 2: Japanese Patent Laying-Open No. 11-256336
Patent Document 3: Japanese Patent Laying-Open No. 04-300104
Patent Document 4: Japanese Patent Laying-Open No. 64-031972

DISCLOSURE OF THE INVENTION

PROBLEMS TO BE SOLVED BY THE INVENTION

The present invention was made in view of the problems as described above, and an object of the present invention is to provide an indexable insert achieving both of wear resistance and chipping resistance as well as excellent adhesiveness between a substrate and a coating layer.

MEANS FOR SOLVING THE PROBLEMS

The present inventors have studied a method for improving wear resistance and chipping resistance of an indexable insert in which a coating layer is formed with the chemical vapor deposition method. Then, the present inventors have found that, by forming a TiCN layer mainly composed of TiCN as one layer in the coating layer, controlling crystal orientation of that TiCN layer, and providing compressive residual stress to any one layer in the coating layer, both of wear resistance and chipping resistance are achieved and adhesiveness between the substrate and the coating layer is also excellent. Based on this finding, the present inventors further conducted study and finally completed the present invention.
Namely, an indexable insert according to the present invention includes a substrate and a coating layer formed on the substrate, the coating layer is formed of a plurality of layers including at least a TiCN layer and at least one layer among the plurality of layers is provided with compressive residual stress, the TiCN layer is a layer mainly composed of TiCN and has highest peak intensity in a (422) plane and second peak intensity in a (311) plane in X-ray diffraction, and a ratio of peak intensity I(422)/I(311) between peak intensity I(422) of the (422) plane and peak intensity I(311) of the (311) plane is not lower than 1.1 and not higher than 10.

The TiCN layer above preferably has an orientation index TC(220) of a (220) plane, not greater than 1. In addition, preferably, the coating layer above includes an outermost layer and an alumina layer in addition to the TiCN layer above, the outermost layer is a layer forming a surface of the coating layer above, mainly composed of any of a carbide, a nitride and a carbonitride of Ti, the alumina layer is a layer mainly composed of $Al_2O_3$, located between the outermost layer and the TiCN layer above, and at least one of the outermost layer above, the alumina layer above and the TiCN layer above is provided with compressive residual stress not smaller than 0.05 GPa and not greater than 2 GPa.

Here, the outermost layer above is preferably composed of a nitride of Ti, and the alumina layer above is preferably a layer mainly composed of $Al_2O_3$ having a κ-type crystal structure.

In addition, the coating layer above preferably includes a TiBN layer composed of $TiB_xN_y$ (where x and y each represent an atomic ratio and relation of $0.001 \leq x/(x+y) \leq 0.04$ is satisfied) directly under the alumina layer above. Moreover, the outermost layer above preferably has a thickness not smaller than 0.05 $\mu$m and not greater than 1 $\mu$m

In addition, the alumina layer above preferably has a thickness not smaller than 0.05 $\mu$m and not greater than 2 $\mu$m, and the coating layer above preferably further includes one or more hard layer formed of a compound composed of at least one element selected from the group consisting of IVa-group elements (Ti, Zr, Hf, and the like), Va-group elements (V, Nb, Ta, and the like) and VIa-group elements (Cr, Mo, W, and the like) in a periodic table, Al, and Si and at least one element selected from the group consisting of carbon, nitrogen, oxygen, and boron.

In addition, the coating layer above is preferably formed with a chemical vapor deposition method, and the coating layer preferably includes a lowermost layer composed of a nitride of Ti and having a thickness not smaller than 0.05 $\mu$m and not greater than 1 $\mu$m. Moreover, the substrate above is preferably formed from any of cemented carbide, cermet, high-speed steel, ceramics, sintered cubic boron nitride, sintered diamond, and sintered silicon nitride.

EFFECTS OF THE INVENTION

Structured as above, the indexable insert according to the present invention achieves both of wear resistance and chipping resistance as well as excellent adhesiveness between the substrate and the coating layer.

BEST MODES FOR CARRYING OUT THE INVENTION

The present invention will be described hereinafter in further detail.

<Indexable Insert>

The indexable insert according to the present invention includes the substrate and the coating layer formed on the substrate. So long as such a basic structure is included, a shape of the indexable insert is not particularly limited and it may have any conventionally known shape.

Such an indexable insert according to the present invention is applicable, for example, to drilling, end milling, milling, turning, metal saw working, gear cutting tool working, reamer working, tapping, crankshaft pin milling, or the like.

<Substrate>

A conventionally known material for the substrate of this type may be used for the substrate for the indexable insert according to the present invention, without particularly limited. Examples of such a material include cemented carbide (such as WC-based cemented carbide, a material containing Co and/or Ni in addition to WC, or a material to which carbide, nitride, carbonitride, or the like of Ti, Ta, Nb, Zr, Hf, Cr, V, or the like is further added), cermet (mainly composed of TiC, TiN, TiCN, or the like), high-speed steel, ceramics (titanium carbide, silicon carbide, silicon nitride, aluminum nitride, aluminum oxide, a mixture thereof, and the like), sintered cubic boron nitride, sintered diamond, sintered silicon nitride, or the like. In the case of employing the cemented carbide as the material, the effect of the present invention is exhibited even when the cemented carbide contains free carbon or an abnormal phase called ε phase in its texture.

In addition, the surface of the substrate may be reformed. For example, in the case of the cemented carbide, a beta (β) removal layer may be formed on its surface, or in the case of the cermet, a surface-hardened layer may be formed. Even if the surface is reformed in such a manner, the effect of the present invention is still exhibited.

<Coating Layer>

The coating layer according to the present invention is formed of a plurality of layers including at least the TiCN layer having specific crystal orientation, and at least one layer among the plurality of layers is provided with compressive residual stress. By thus including the TiCN layer having specific crystal orientation, strength against shear deformation is very high and hence chipping resistance is excellent. In addition, not only chipping resistance is improved but also wear resistance is enhanced, and hence both of wear resistance and chipping resistance can be improved in a balanced manner. Moreover, as at least one of the plurality of layers constituting the coating layer is provided with compressive residual stress, propagation of a crack generated in a surface of the coating layer to the entire coating layer due to impact during cutting is suppressed and chipping resistance is further improved. Meanwhile, by allowing tensile residual stress to remain in a layer located on an inner side relative to the layer provided with compressive residual stress (that is, each layer located on the substrate side relative to that layer), the coating layer does not self-destruct but exhibits excellent wear resistance, and adhesiveness to the substrate is also excellent. Thus, the coating layer according to the present invention achieves both of high wear resistance and high chipping resistance as well as also excellent adhesiveness to the substrate, as characteristics above being combined.

The compressive residual stress above refers to internal stress (intrinsic strain) remaining in the coating layer, and is generally expressed by a "-" (minus) numeric value (unit: "GPa" in the present invention). In the present invention, however, except for a case of comparison with tensile residual stress or the like, this minus sign is abbreviated unless otherwise specified. Therefore, in expressing magnitude of the compressive residual stress without particularly using a numeric value, a larger absolute value of the numeric value above expresses larger compressive residual stress, whereas a smaller absolute value of the numeric value above expresses smaller compressive residual stress. In contrast, tensile residual stress also refers to internal stress (intrinsic strain) remaining in the coating layer, and is generally expressed by a "+" (plus) numeric value (unit: "GPa" in the present invention).

Such compressive residual stress or tensile residual stress may be measured with a $\sin^2\psi$ method using an X-ray stress measurement apparatus, and the stress can be measured in such a manner that stress at any three or more points located in a flat portion such as a rake face or a flank face of the indexable insert (these points are preferably selected at a distance from each other by at least 0.5 mm, in order to represent the stress in that area) is measured with the $\sin^2\psi$ method and the average thereof is calculated.

Such an $\sin^2\psi$ method using an X-ray is widely used as a method of measuring residual stress in a polycrystalline material, and the method described in detail on pages 54-67 of "X-ray Stress Measurement" (The Society of Materials Science, Japan, 1981, published by Yokendo Co., Ltd.) may be used. It is noted that the residual stress as described above can be measured also by using radiation light. This method is advantageous in that residual stress distribution in a direction of thickness of the coating layer can be found.

It is noted that such a coating layer according to the present invention suitably has a thickness not smaller than 0.1 μm and not greater than 30 μm and preferably not smaller than 1 μm and not greater than 20 μm. In addition, the coating layer according to the present invention may be formed to cover the entire surface of the substrate or to partially cover the substrate.

<TiCN Layer>

The coating layer according to the present invention includes at least the TiCN layer. The TiCN layer is a layer mainly composed of TiCN, it has highest peak intensity in the (422) plane and second peak intensity in the (311) plane in X-ray diffraction, and a ratio of peak intensity I(422)/I(311) between peak intensity I(422) of the (422) plane and peak intensity I(311) of the (311) plane is not lower than 1.1 and not higher than 10.

By setting the peak intensity ratio I(422)/I(311) to the range above, particularly excellent chipping resistance can be obtained, and the reason therefor is estimated as follows. The (422) plane and the (311) plane have angles of approximately 30° and approximately 31° with respect to the (220) plane, which is a primary glide plane of TiCN, respectively, and as orientation of these planes is higher, strength against shear deformation during cutting becomes very high. In particular, it was clear that, when the (422) plane attains the highest peak and the peak intensity ratio I (422)/I(311) is not lower than 1.1 and not higher than 10, balance between chipping resistance and wear resistance was particularly excellent. In addition, in this case, the coating layer can sufficiently withstand impact during blast treatment to the surface of the coating layer as will be described later, destruction of the coating layer can be prevented, and sufficient compressive residual stress can be provided. A more preferred range of the peak intensity ratio I(422)/I(311) above is not lower than 4 and not higher than 10 and further preferably not lower than 5 and not higher than 10.

Such a TiCN layer preferably has an orientation index TC(220) of the (220) plane, not greater than 1. Here, an orientation index TC(hkl) is defined as shown in the following equation (I).

$$TC(hkl) = \frac{I(hkl)}{I_0(hkl)} \left( \frac{1}{8} \sum \frac{I(hkl)}{I_0(hkl)} \right)^{-1} \quad \cdots (I)$$

where I(hkl) represents peak intensity (diffraction intensity) of a (hkl) plane that was subjected to measurement, $I_0$(hkl) represents an average value of powder diffraction intensity of TiC and TiN forming the (hkl) plane under JCPDS file (Joint Committee on Powder Diffraction Standards file; 32-1383 (TiC), 38-1420 (TiN)), and (hkl) represents eight planes of (111), (200), (220), (311), (331), (420), (422), and (511).

By weakening orientation of the (220) plane (that is, by making smaller orientation index TC(220)), chipping resistance of the TiCN layer can further be improved, the coating layer does not destruct even after compressive residual stress is provided through blast treatment which will be described later, and a good coating film form can be maintained. Thus, balance between chipping resistance and wear resistance is excellent. Such orientation index TC(220) is more preferably not greater than 0.5 and further preferably not greater than 0.3.

Such a TiCN layer is mainly composed of TiCN. Here, being mainly composed of TiCN means that 90 mass % or more TiCN is contained and preferably the TiCN layer is composed only of TiCN except for inevitable impurities.

It is noted that an atomic ratio between elements included in TiCN (carbonitride of Ti) includes all atomic ratios that have conventionally been known, and the atomic ratio is not particularly limited. For example, the atomic ratio between Ti and CN is preferably set such that a ratio of Ti is set to 0.8 to 1.4 with respect to the total of CN assumed as 1, and the atomic ratio between C and N is preferably set such that a ratio of N is set to 0.8 to 1.2 with respect to C assumed as 1.

Such a TiCN layer is preferably formed with a MT-CVD (medium temperature CVD) method, and thus particularly satisfactory chipping resistance and wear resistance are exhibited. Here, the MT-CVD method refers to a chemical vapor deposition method (CVD method) in which a film is deposited at a relatively low temperature from approximately 830 to 950°C, in contrast to a normal chemical vapor deposition method in which a film is deposited at a temperature from approximately 950 to 1050°C in many cases. With such an MT-CVD method, the TiCN layer having crystal orientation as described above can be formed by adopting such a condition that a particularly small amount of $CH_3CN$ not higher than 0.5 volume % is used for film deposition (in forming a lowermost layer as will be described later directly under the TiCN layer, the lowermost layer is formed at a low temperature not higher than 850°C).

It is noted that the TiCN layer preferably has a thickness not smaller than 0.1 $\mu$m and not greater than 15 $\mu$m, and further preferably the upper limit thereof is 12 $\mu$m and the lower limit is 0.5 $\mu$m. If the thickness exceeds 15 $\mu$m, chipping resistance may be lowered, which is not preferred. If the thickness is smaller than 0.1 $\mu$m, the excellent effect as described above may not be exhibited.

<Outermost Layer and Alumina Layer>

The coating layer according to the present invention preferably includes the outermost layer and the alumina layer in addition to the TiCN layer above.

Here, the outermost layer is a layer forming a surface of the coating layer mainly composed of any of a carbide, a nitride and a carbonitride of Ti. Being mainly composed of any of a carbide, a nitride and a carbonitride of Ti means that any of a carbide, a nitride and a carbonitride of Ti is contained by 90 mass % or more and preferably means that the layer is composed only of any of the carbide, the nitride and the carbonitride of Ti except for inevitable impurities. In addition, regarding a mass ratio between Ti and an element other than Ti (that is, C, N and CN), in each of the carbide, the nitride and the carbonitride of Ti, Ti preferably accounts for 50 mass % or more.

The nitride of Ti (that is, a compound expressed as TiN) is particularly preferred among the carbide, the nitride and the carbonitride of Ti. TiN is clearest in color (exhibits gold color) among these compounds, and TiN is advantageous in that identification of a corner of the cutting insert after use for cutting is easy.

In the present invention, when a compound is expressed with a chemical formula such as TiN and when an atomic ratio is not particularly limited, all atomic ratios that have conventionally been known are encompassed and the atomic ratio is not necessarily limited only to those in a stoichiometric range. For example, when a compound is simply denoted as "TiCN", the atomic ratio between "Ti", "C" and "N" is not limited only to 50:25:25. Alternatively, when a compound is simply denoted as "TiN", the atomic ratio between "Ti" and "N" is not limited only to 50:50. All atomic ratios that have conventionally been known are encompassed as the atomic ratio.

The outermost layer according to the present invention preferably has a thickness not smaller than 0.05 $\mu$m and not greater than 1 $\mu$m. In addition, the upper limit of the thickness is 0.8 $\mu$m and more preferably 0.6 $\mu$m, and the lower limit is 0.1 $\mu$m and more preferably 0.2 $\mu$m. If the thickness is smaller than 0.05 $\mu$m, an effect of providing compressive residual stress is not sufficient, that is, providing compressive residual stress is not much effective in improving chipping resistance. When the thickness exceeds 1 $\mu$m, adhesiveness to the layer located on the inner side of the outermost layer may become poorer.

Meanwhile, the alumina layer above is a layer mainly composed of $Al_2O_3$, located between the outermost layer above and the TiCN layer above. Such an alumina layer exhibits good performance against oxidation wear during high-speed cutting, and serves to improve wear resistance. Here, being mainly composed of $Al_2O_3$ means that 90 mass % or more $Al_2O_3$ is contained and preferably means that the alumina layer is composed only of $A_2O_3$ except for inevitable impurities.

Such an alumina layer is desirably a layer mainly composed of $Al_2O_3$ having a $\kappa$-type crystal structure (hereinafter may be denoted as K-$Al_2O_3$). In general, in high-speed cutting, $Al_2O_3$ having an $\alpha$-type crystal structure (hereinafter may be denoted as $\alpha$-$Al_2O_3$) is advantageous in its excellent wear resistance. As will be described later, however, when blast treatment for providing compressive residual stress is performed, the alumina layer itself may destruct at the same time with the treatment and the alumina layer may peel off together with the outermost layer or the like. In contrast, with the use of K-$Al_2O_3$, destruction does not occur even in the blast treatment, and peeling off of the alumina layer together with the outermost layer or the like can be prevented, which is preferred. It is noted that such a crystal structure can be observed by using X-ray diffraction.

Such an alumina layer preferably has a thickness not smaller than 0.05 $\mu$m and not greater than 2 $\mu$m, and further preferably the upper limit thereof is 1.5 $\mu$m and the lower limit is 0.5 $\mu$m. If the thickness exceeds 2 $\mu$m, chipping resistance may be lowered, which is not preferred. When the thickness is smaller than 0.05 $\mu$m, sufficient wear resistance may not be exhibited.

<Compressive Residual Stress>

The coating layer according to the present invention is formed of a plurality of layers as described above, and at least one of the plurality of layers is preferably provided with compressive residual stress. In particular, at least one of the outermost layer above, the alumina layer above and the TiCN layer above is preferably provided with compressive residual stress not smaller than 0.05 GPa and not greater than 2 GPa. The provided compressive residual stress is further preferably not smaller than 0.1 GPa and not greater than 2 GPa. The upper limit value of such compressive residual stress is more preferably not greater than 1.8 GPa.

If the provided compressive residual stress is smaller than 0.05 GPa, an effect of improvement in chipping resistance may not be exhibited. If the provided compressive residual stress exceeds 2 GPa, adhesiveness becomes poorer due to a difference in stress from a layer formed on the inner side relative to that layer, and that layer peels off in an early stage after start of cutting, and hence chipping resistance may be lowered.

<TiBN Layer>

The coating layer according to the present invention preferably includes the TiBN layer composed of $TiB_xN_y$ (where x and y each represent an atomic ratio and relation of $0.001 \leq x/(x+y) \leq 0.04$ is satisfied) directly under the alumina layer above (a position on the substrate side, in contact with the alumina layer). Since such a TiBN layer has a surface having a texture of very fine needles, it exhibits excellent adhesiveness to the alumina layer.

When blast treatment or the like is performed in order to provide the surface of the coating layer with compressive residual stress as will be described later, such a problem that the alumina layer may peel off or fall off arises. By forming such a TiBN layer directly under the alumina layer, such a problem can be solved. In the expression above, x and y particularly preferably satisfy relation of $0.003 \leq x/(x+y) \leq 0.02$. Thus, particularly satisfactory adhesive force to the alumina layer is obtained. In addition, regarding the atomic ratio between Ti and BN, the ratio of Ti is preferably in a range from 0.8 to 1.5, with the total of BN being assumed as 1.

It is noted that such a TiBN layer can contain an element included in another layer forming the coating layer according to the present invention (in particular, an element included in a layer in contact with the TiBN layer). Such a TiBN layer preferably has a thickness not smaller than 0.05 $\mu$m and not greater than 1 $\mu$m, and further preferably the upper limit thereof is 0.8 $\mu$m and the lower limit is 0.1 $\mu$m. If the thickness exceeds 1 $\mu$m, wear resistance may be lowered, which is not preferred. If the thickness is smaller than 0.05 $\mu$m, sufficient adhesiveness to the alumina layer may not be exhibited.

It is noted that such a TiBN layer is preferably provided with compressive residual stress not smaller than 0.05 GPa and not greater than 2 GPa, because adhesiveness to the alumina layer above and the TiCN layer which will be described later is improved thereby.

<Hard Layer>

The coating layer according to the present invention preferably further includes one or more hard layer formed of a compound composed of at least one element selected from the group consisting of IVa-group elements, Va-group elements and VIa-group elements in the periodic table, Al, and Si and at least one element selected from the group consisting of carbon, nitrogen, oxygen, and boron. Such a hard layer can be formed anywhere in the coating layer according to the present invention, except for as the outermost layer. For example, the hard layer may be formed between the outermost layer and the alumina layer, between the alumina layer (the TiBN layer) and the TiCN layer, between the TiCN layer and the substrate (the lowermost layer), or the like. When the hard layer is located between the outermost layer and the alumina layer or between the alumina layer (the TiBN layer) and the TiCN layer, the hard layer is preferably provided with compressive residual stress not smaller than 0.05 GPa and not greater than 2 GPa, because adhesiveness between the layers can be improved thereby.

Examples of compounds forming such a hard layer include TiC, TiN, TiCN, TiNO, TiCNO, $TiB_2$, $TiO_2$, TiBN, TiBNO, TiCBN, TiCrCN, ZrC, $ZrO_2$, HfC, HfN, TiAlN, AlCrN, CrN, VN, TiSiN, TiSiCN, AlTiCrN, TiAlCN, ZrCN, ZrCNO, AlN, AlCN, ZrN, TiZrN, TiAlC, NbC, NbN, NbCN, $Mo_2C$, WC, $W_2C$, and the like.

Such a hard layer preferably has a thickness not smaller than 0.1 $\mu$m and not greater than 15 $\mu$m per one layer.

<Lowermost Layer>

The coating layer according to the present invention preferably includes the lowermost layer (layer in contact with the substrate) composed of a nitride of Ti and having a thickness not smaller than 0.05 $\mu$m and not greater than 1 $\mu$m The lowermost layer composed of such a nitride of Ti (TiN) is high in adhesiveness to the substrate, and even when the surface of the coating layer is subjected to blast treatment in order to provide at least one layer in the coating layer with compressive residual stress as will be described later, the coating layer can be prevented from peeling off in its entirety. In addition, even when at least one layer in the coating layer is provided with compressive residual stress as in the present invention, by forming such a lowermost layer, an excellent effect of obtaining adhesiveness sufficient for withstanding cutting is exhibited.

The lower limit of the thickness of such a lowermost layer is preferably 0.1 $\mu$m.

<Manufacturing Method>

The coating layer according to the present invention is preferably formed with the chemical vapor deposition method (CVD method). Thus, each layer in the coating layer has tensile residual stress until blast treatment which will be described later is performed, and adhesiveness to the substrate is very high. In addition, according to the present invention, the surface of the coating layer formed with such a chemical vapor deposition method is subjected to blast treatment, so that at least one layer in the coating layer is provided with compressive residual stress. When each layer in the coating layer is formed with the chemical vapor deposition method, balance between adhesiveness and chipping resistance is particularly excellent.

A conventionally known method can be used as such a chemical vapor deposition method without particularly limited, and a condition or the like is not limited. For example, a film deposition temperature from approximately 850 to 1050°C can be adopted, and a conventionally known gas such as a nitrile-based gas including acetonitrile can be used without particularly limited.

In addition, for example, blast treatment may be used as a method of providing at least one layer in the coating layer with compressive residual stress, and the treatment can be performed by causing direct collision of powders of metal such as steel balls or powders of ceramics such as alumina with the surface of the coating layer or by causing collision of a mixture of such powders with a solvent such as water with the surface of the coating layer. Specific conditions for collision or the like can be adjusted as appropriate, depending on a structure of the coating layer, magnitude of compressive residual stress to be provided, or the like, however, if collision is too week, compressive residual stress is not provided. Therefore, collision at moderate strength is preferred. More preferred specific conditions include a discharge pressure (a pressure of compressed air or the like serving as a medium in collision of the metal powders or the ceramics powders as described above) not lower than 0.08 MPa and not higher than 0.3 MPa, a time period for collision not shorter than 3 seconds and not longer than 20 seconds, and an injection distance not smaller than 20 mm and not greater than 50 mm (a distance from a discharge port (tip end of a nozzle) of the powders above to an injection target). The surface of the coating layer is subjected to blast treatment under such conditions, so that at least one of the plurality of layers forming the coating layer can be provided with compressive residual stress not smaller than 0.05 GPa and not greater than 2 GPa.

<Examples>

In the following, the present invention will be described in further detail with reference to examples, however, the present invention is not limited thereto.

An indexable insert was fabricated by employing a cutting insert made of cemented carbide composed of 1.5 mass % TaC, 1.0 mass % NbC, 9.0 mass % Co, and remainder WC (containing inevitable impurities) (shape: CNMG120408N-UX manufactured by Sumitomo Electric Hardmetal Corp.) as the substrate and by forming each layer in the coating layer shown in Table 1 with a known thermal CVD method (layers were formed on the substrate, successively from the one in the left in Table 1).

For example, regarding Example 1 in Table 1, TiN (lowermost layer) of 0.2 $\mu$m and TiCN of 6.5 $\mu$m (formed with the MT-CVD method, the TiCN layer) were successively formed on the substrate, and thereafter TiBN of 0.4 $\mu$m (the TiBN layer), K-Al$_2$O$_3$ of 1.0 $\mu$m (the alumina layer) and TiN of 0.7 $\mu$m (the outermost layer) were deposited.

The TiN layer above directly on the substrate (that is, the lowermost layer) was formed under the following conditions. Namely, a reaction gas composed of 2.0 volume % TiCl$_4$, 50 volume % N$_2$, and H$_2$ as the remainder was employed, the pressure was set to 6.7 kPa, and the temperature was set to 840°C.

In addition, the TiCN layer above was formed with the MT-CVD method under the following conditions. Namely, a reaction gas composed of 2.0 volume % TiCl$_4$, 0.5 volume % CH$_3$CN, 50 volume % N$_2$, and H$_2$ as the remainder was employed, the pressure was set to 6.7 kPa, and the temperature was set to 840°C. Thus, in particular the lowermost layer was formed at a low temperature not higher than 850°C and the TiCN layer was deposited with the use of a small amount of CH$_3$CN, that is, not higher than 0.5 volume %, so that the TiCN layer could be deposited while the TiCN layer was controlled to have specific crystal orientation as desired in the present invention.

Moreover, the TiBN layer above was formed under the following conditions. Namely, a reaction gas composed of 2.0 volume % TiCl$_4$, 0.01 volume % BCl$_3$, 10.0 volume % N$_2$, and H$_2$ as the remainder was employed, the pressure was set to 4.0 kPa, and the temperature was set to 930°C. Thus, in particular when the pressure is set in a range from 2.0 to 4.2 kPa, adhesiveness to the alumina layer is high, which is preferred.

Further, conditions for depositing K-Al$_2$O$_3$ (the alumina layer) were set as follows. A reaction gas composed of 5.0 volume % AlCl$_3$, 2.0 volume % CO$_2$ and H$_2$ as the remainder was employed, the pressure was set to 6.0 kPa, and the temperature was set to 1000°C.

The total thickness of the coating layer thus deposited is shown in the field of "Total Film Thickness" in Table 1. In Table 1, the layer in the coating layer, that contains Ti in its composition, shown in the rightmost portion, serves as the outermost layer (in Examples 24 and 25, the layer containing Zr was formed as the surface of the coating layer), and denotation as K-Al$_2$O$_3$ or $\alpha$-Al$_2$O$_3$ represents the alumina layer. In addition, denotation as TiBN represents the TiBN layer, denotation as TiCN represents the TiCN layer, and denotation of the compound other than those represents the lowermost layer (TiN shown in the leftmost portion) or the hard layer. Namely, in the field of the coating layer in Table 1, it is indicated that each layer is composed of a compound in accordance with each denotation.

In addition, after the coating layer was formed as described above, a rake face and a flank face were equally subjected to blast treatment in which balls made of alumina and having an average size of 50 $\mu$m were caused to collide for 5 seconds using compressed air at 0.1 MPa, with its injection distance being set to 30 mm, from a direction of 45° with respect to a cutting-edge ridgeline portion while turning the cutting insert at 60 rpm, so that at least one layer in the coating layer was provided with compressive residual stress. The indexable insert according to the present invention was thus fabricated. It is noted that each layer in the coating layer located on the inner side (on the substrate side) relative to the TiCN layer has tensile residual stress.

Compressive residual stress provided to the coating layer was determined by using the sin$^2\psi$ method with the X-ray stress measurement apparatus described above, and the results are shown in Table 1. For example, it is shown that the TiCN layer in the indexable insert in Example 1 was provided with compressive residual stress of 0.6 GPa, the alumina layer was provided with compressive residual stress of 0.8 GPa, and the outermost layer was provided with compressive residual stress of 0.9 GPa. It is noted that, in Table 1, a numeric value representing compressive residual stress is shown with a "minus" sign, for distinction from tensile residual stress provided with a "plus" sign.

In addition, x and y in TiB$_x$N$_y$ forming the TiBN layer above were determined based on EPMA (Electron Probe Micro Analysis), and a value of x/(x+y) is shown in Table 1. In Example 1, x/(x+y) was 0.004.

Moreover, an X-ray diffraction apparatus ("RINT2400" manufactured by RIGAKU Corporation) was used to subject the TiCN layer to X-ray diffraction, and it was confirmed that the TiCN layer had the highest peak intensity in the (422) plane and the second peak intensity in the (311) plane. Further, the peak intensity ratio I(422)/I(311) between peak intensity I(422) of the (422) plane and peak intensity I(311) of the (311) plane was measured and shown in Table 1 (the field of "I(422)/I(311) of TiCN Layer"). Similarly, orientation index TC(220) of the (220) plane was measured and shown in Table 1 (the field of "TC(220) of TiCN Layer").

Example 1 was described above, and indexable inserts according to Examples 2 to 25 and Comparative Examples 1 to 7 were similarly fabricated and shown in Table 1. It is noted that, in Comparative Example 1, the outermost layer, the alumina layer and the TiCN layer had tensile residual stress by not subjecting the surface of the coating layer to blast treatment in Example 1. Comparative Example 2 was fabricated such that peak intensity ratio I(422)/I(311) was smaller than 1.1, as compared with Example 1. Comparative Example 3 was fabricated such that the outermost layer was not formed and the alumina layer and the TiCN layer had tensile residual stress, as compared with Example 1.

Comparative Example 4 was fabricated such that peak intensity ratio I(422)/I(311) was smaller than 1.1 and orientation index TC(220) exceeds 1, as compared with Example 1. Comparative Example 5 was fabricated such that peak intensity ratio I(422)/I(311) exceeds 10, as compared with Example 1. Comparative Example 6 was fabricated such that the outermost layer, the alumina layer and the TiCN layer had tensile residual stress, and Comparative Example 7 was fabricated such that the outermost layer, the alumina layer and the TiCN layer had tensile residual stress and the lowermost layer was not formed.

It was confirmed based on X-ray diffraction of the TiCN layer that each of the indexable inserts in Examples had the highest peak intensity in the (422) plane and the second peak intensity in the (311) plane.

Table 1

| | | Coating Layer | Total Film Thickness ($\mu$m) | I(422)/I (311) of TiCN Layer | IC(220) TiCN Layer | Residual of Stress of TiCN (GPa) | Residual Stress of Alumina (GPa) | Residual Stress of Outermost Layer (GPa) | $TiB_xN_y$ x/(X+y) |
|---|---|---|---|---|---|---|---|---|---|
| | Example 1 | TiN(0.2$\mu$m)/ TiCN(MT-CVD 6.5$\mu$m) /TiBN (0.4$\mu$m)/$\kappa$-Al$_2$O$_3$ (1.0$\mu$m)/TiN (0.7$\mu$m) | 8.8 | 8.25 | 0.12 | -0.6 | -0.8 | -0.9 | 0.004 |
| | Example 2 | TiN(0.4$\mu$m)/ TiCn(MT-CVD 8.2$\mu$m) /TiBN (0.5$\mu$M)/$\kappa$-Al$_2$O$_3$ (1.2$\mu$m)/ TiCN (0.21$\mu$M) /TiN (0.51$\mu$M) | 11 | 7.14 | 0.32 | +0.2 | +0.2 | -0.2 | 0.032 |
| | Example 3 | TiN(0.2$\mu$m)/ TiCN(MT-CVD 4.6$\mu$m) /TiBN (0.71$\mu$m)/$\kappa$-Al$_2$O$_3$ (0.8$\mu$m) /ZrO$_2$ (0.6$\mu$m)/TiN (0.7$\mu$m) | 7.6 | 5.15 | 0.42 | +0.4 | -0.2 | -0.3 | 0.012 |
| | Example 4 | TiN (0.06$\mu$m)/ TiCN(MT-CVD 6.2$\mu$m) /TiBN (0.8$\mu$m)/$\kappa$-Al$_2$O$_3$ (1.4$\mu$m)/ TiCN (0.2$\mu$m)/TiN (0.2$\mu$m) | 8.86 | 5.56 | 0.27 | -0.2 | -0.2 | -0.2 | 0.024 |

(continued)

| | Coating Layer | Total Film Thickness ($\mu$m) | I(422)/I(311) ofTiCN Layer | IC(220) TiCN Layer | Residual of Stress of TiCN (GPa) | Residual Stress of Alumina (GPa) | Residual Stress of Outermost Layer (GPa) | TiB$_x$N$_y$ x/(X+y) |
|---|---|---|---|---|---|---|---|---|
| Example 5 | TiN(0.9$\mu$m)/ TiCN(MT-CVD 6.0$\mu$m) /TiBN (0.3$\mu$m)/$\kappa$-Al$_2$O$_3$ (0.4$\mu$m)/ TiCN (0.2$\mu$m)/TiN (0.6$\mu$m) | 8.6 | 9.84 | 0.15 | -0.3 | -0.4 | -0.3 | 0.005 |
| Example 6 | TiN(0.4$\mu$m)/ TiCN(MT-CVD 3.8$\mu$m) /TiBN (0.6$\mu$m)/$\kappa$-Al$_2$O$_3$ (1.7$\mu$m)/ TiCN (0.4$\mu$m)/TiN (0.5$\mu$m) | 7,4 | 6.34 | 0.47 | -1 | -1.2 | -1.1 | 0.018 |
| Example 7 | TiN(0.2$\mu$m)/ TiCN(MT-CVD 2.5$\mu$m) /TiZrCN (4.2$\mu$m)/ TiBN (0.6$\mu$m)/$\kappa$-Al$_2$O$_3$ (1.5$\mu$m)/TiN (0.5$\mu$m) | 9.5 | 7.24 | 0.87 | -0.1 | -0.2 | -0,4 | 0.015 |
| xample 8 | TiN(0.4$\mu$m)/ TiCrCN (4.5$\mu$m)/ TiCN(MT-CVD 1.5$\mu$m) /TiBN (0.6$\mu$m)/$\kappa$-Al$_2$O$_3$ (1.5$\mu$m)/TiN (0.5$\mu$m) | 9 | 3.76 | 0.22 | -0.5 | -0.8 | -1.2 | 0.018 |

(continued)

| | Coating Layer | Total Film Thickness ($\mu$m) | I(422)/I (311) of TiCN Layer | IC(220) TiCN Layer | Residual of Stress of TiCN (GPa) | Residual Stress of Alumina (GPa) | Residual Stress of Outermost Layer (GPa) | $TiB_xN_y$ x/(X+y) |
|---|---|---|---|---|---|---|---|---|
| Example 9 | TiN(0.2$\mu$m)/ TiCN(MT-CVD 6.1$\mu$m) /TiBN (0.7$\mu$m)/$\kappa$-$Al_2O_3$ (1.4$\mu$m)/ TiCN (0.5$\mu$m)/TiN (0.5$\mu$m) | 9.4 | 6.25 | 1.25 | -0.2 | -0.2 | -0.2 | 0.008 |
| Example 10 | TiN(0.7$\mu$m)/ TiCN(MT-CVD 9.5$\mu$m) /TiN(0.5$\mu$m) | 10.7 | 7.26 | 0.12 | -0.2 | - | -0.2 | - |
| Example 11 | TiN(0.4$\mu$m)/ TiCN(MT-CVD 5.4$\mu$m) /TiBN (0.7$\mu$m)/$\kappa$-$Al_2O_3$ (1.0$\mu$m)/ TiCN (0.4$\mu$m)/TiN (0.5$\mu$m) | 8.4 | 8.71 | 0.38 | -0.02 | -0.03 | -0.04 | 0.012 |
| Example 12 | TiN(0.5$\mu$m)/ TiCN(MT-CVD 4.8$\mu$m) /TiBN (0.3$\mu$m)/$\kappa$-$Al_2O_3$ (0.7$\mu$m)/ TiCN (0.5$\mu$m)/TiN (0.7$\mu$m) | 7.5 | 9.18 | 0.42 | -2.1 | -2.1 | -2.4 | 0.027 |
| Example 13 | TiN(0.5$\mu$m)/ TiCN(MT-CVD7.8$\mu$m) /TiBN (0.7$\mu$m)/$\kappa$-$Al_2O_3$ (1.2$\mu$m)/ TiCN (0.5$\mu$m) | 10.7 | 8.46 | 0.32 | +0.3 | -0.3 | -0.3 | 0.009 |

(continued)

| | | Coating Layer | Total Film Thickness ($\mu$m) | I(422)/I (311) of TiCN Layer | IC(220) TiCN Layer | Residual of Stress of TiCN (GPa) | Residual Stress of Alumina (GPa) | Residual Stress of Outermost Layer (GPa) | $TiB_xN_y$ x/(X+y) |
|---|---|---|---|---|---|---|---|---|---|
| | Example 14 | TiN(0.5$\mu$m)/ TiCN(MT-CVD 3.5$\mu$m) /TiBN (0.4$\mu$m)/$\kappa$-$Al_2O_3$ (0.8$\mu$m)/TiC (0.6$\mu$m) | 5.8 | 4.21 | 0.17 | -0.4 | -0.4 | -0.5 | 0.005 |
| | Example 15 | TiN(0.2$\mu$m)/ TiCN(MT-CVD 4.4$\mu$m) /TiBN (0.2$\mu$m)/$\alpha$-$Al_2O_3$ (1.0$\mu$m)/ TiCN (0.2$\mu$m)/TiN (0.8$\mu$m) | 8.8 | 5.24 | 0.26 | -1.2 | -1.4 | -1.8 | 0.004 |
| | Example 16 | TiN(0.3$\mu$m)/ TiCN(MT-CVD 4.7$\mu$m) /TiCNO (0.2$\mu$m)$\kappa$-$Al_2O_3$ (0.8$\mu$m)/TiN (0.5$\mu$m) | 6.5 | 7.15 | 0.24 | -1.4 | -1.2 | -1.5 | - |
| | Example 17 | TiN(0.6$\mu$m)/ TiCN(MT-CVD 7.2$\mu$m) /TiBN (0.2$\mu$m)/$\kappa$-$Al_2O_3$ (0.7$\mu$m)/ TiCN (0.4$\mu$m)/TiN (0.5$\mu$m) | 9.6 | 8.63 | 0.07 | -0.5 | -0.5 | -0.6 | 0.0008 |
| | Example 18 | TiN(0.2$\mu$m)/ TiCN(MT-CVD 3.0$\mu$m) /TiBN (0.5$\mu$m)/$\kappa$-$Al_2O_3$ (0.7$\mu$m)/ TiCN (0.2$\mu$m)/TiN (0.5$\mu$m) | 5.1 | 5.21 | 0.42 | -0.5 | -0.4 | -0.6 | 0.05 |

(continued)

| | | Coating Layer | Total Film Thickness ($\mu$m) | I(422)/I(311) ofTiCN Layer | IC(220) TiCN Layer | Residual of Stress of TiCN (GPa) | Residual Stress of Alumina (GPa) | Residual Stress of Outermost Layer (GPa) | $TiB_xN_y$ x/(X+y) |
|---|---|---|---|---|---|---|---|---|---|
| | Example 19 | TiN(0.3$\mu$m)/TiCN(MT-CVD 8.2$\mu$m)/TiBN (0.5$\mu$m)/$\kappa$-$Al_2O_3$ (1.2$\mu$m)/TiN (1.2$\mu$m) | 11.4 | 6.38 | 0.19 | -0.7 | -0.8 | -0.8 | 0.012 |
| | Example 20 | TiN(0.2$\mu$m)/TiCN(MT-CVD 6.0$\mu$m)/TiBN (0.5$\mu$m)/$\kappa$-$Al_2O_3$ (2.2$\mu$m)/TiN (0.5$\mu$m) | 9.4 | 8.67 | 0.26 | -1 | -1.8 | -1.8 | 0.008 |
| | Example 21 | TiC(0.2$\mu$m)/TiCN(MT-CVD 4.6$\mu$m)/TiBN (0.4$\mu$m)/$\kappa$-$Al_2O_3$ (1.0$\mu$m)/TiCN (0.2$\mu$m)/TiN (0.7$\mu$m) | 7.1 | 1.26 | 0.42 | -0.6 | -1.2 | -1.4 | 0.007 |
| | Example 22 | TiN(1.2$\mu$m)/TiCN(MT-CVD4.0$\mu$m)/TiBN (0.5$\mu$m)/$\kappa$-$Al_2O_3$ (1.2$\mu$m)/TiCN (0.5$\mu$m)/TiN (0.5$\mu$m) | 7.9 | 1.17 | 0.46 | -0.1 | -0.7 | -0.7 | 0.03 |
| | Example 23 | TiCN(MT-CVD 4.5$\mu$m)/TiBN (0.8$\mu$m)/$\kappa$-$Al_2O_3$ (0.6$\mu$m)/TiN (0.8$\mu$m) | 6.7 | 1.57 | 0.68 | -0.5 | -0.9 | -1 | 0.02 |
| | Example 24 | TiCN(MT-CVD7.5$\mu$m)/TiN(1.5$\mu$m)/ZrN(0.8$\mu$m) | 9.8 | 1.12 | 1.65 | +0.2 | - | -0.1(ZrN) | - |

(continued)

| | Coating Layer | Total Film Thickness ($\mu$m) | I(422)/I (311) ofTiCN Layer | IC(220) TiCN Layer | Residual of Stress of TiCN (GPa) | Residual Stress of Alumina (GPa) | Residual Stress of Outermost Layer (GPa) | TiB$_x$N$_y$ x/(X+y) |
|---|---|---|---|---|---|---|---|---|
| Example 25 | TiC(0.2$\mu$m)/ TiCN(MT-CVD6.4$\mu$m) /TiZrN (0.4$\mu$m) | 7 | 3.45 | 0.82 | -0.1 | - | -0,2(TiZrN) | - |
| Comparative Examle 1 | TiN(0.2$\mu$m)/ TiCN(MT-CVD 6.5$\mu$m) /TiBN (0.4$\mu$m)/$\kappa$-Al$_2$O$_3$ (1.0$\mu$m)/TiN (0.7$\mu$m) | 8.8 | 8.24 | 0.21 | +0.5 | +0.2 | +0.3 | 0.004 |
| Comparative Example 2 | TiN(0.2$\mu$m)/ TiCN(MT-CVD 6.5$\mu$m) /TiBN (0.4$\mu$m)/$\kappa$-Al$_2$O$_3$ (1.0$\mu$m)/TiN (0.7$\mu$m) | 8.8 | 0.82 | 0.95 | -0.5 | -0.6 | -0.8 | 0.004 |
| Comparative Example 3 | TiN(0.2$\mu$m)/ TiCN(MT-CVD 6.5$\mu$m) /TiBN (0.4$\mu$m)/$\kappa$-Al$_2$O$_3$ (1.0$\mu$m) | 8.1 | 7.51 | 0.34 | +0.7 | +0.5 | - | 0.004 |
| Comparative Example 4 | TiN(0.2$\mu$m)/ TiCN(MT-CVD 6.5$\mu$m) /TiBN (0.4$\mu$m)/$\kappa$-Al$_2$O$_3$ (1.0$\mu$m)/TiN (0.7$\mu$m) | 8.8 | 0.42 | 1.52 | +0.1 | -0.2 | -0.3 | 0.004 |
| Comparative Example 5 | TiN(0.2$\mu$m)/ TiCN(MT-CVD 6.5$\mu$m) /TiBN (0.4$\mu$m)/$\kappa$-Al$_2$O$_3$ (1.0$\mu$m)/TiN (0.7$\mu$m) | 8.8 | 10.50 | 1.05 | +0.2 | -0.2 | -0.3 | 0.004 |

(continued)

| | Coating Layer | Total Film Thickness (μm) | I(422)/I(311) of TiCN Layer | IC(220) TiCN Layer | Residual of Stress of TiCN (GPa) | Residual Stress of Alumina (GPa) | Residual Stress of Outermost Layer (GPa) | $TiB_xN_y$ x/(X+y) |
|---|---|---|---|---|---|---|---|---|
| Comparative Example 6 | TiN(0.3μm)/ TiCN(MT-CVD 7.8μm) /TiBN (0.5μm)/α-$Al_2O_3$ (0.8μm)/TiN (0.5μm) | 9.7 | 6.54 | 0.42 | +0.5 | +0.1 | +0.3 | 0.014 |
| Comparative Example 7 | TiCN(MT-CVD4.8μm) /TiBN (0.6μm)/α-$Al_2O_3$ (1.5μm)/TiN (0.5μm) | 7.4 | 2.48 | 0.88 | +0.6 | +0.1 | +0.1 | 0.003 |

These indexable inserts (Examples 1 to 25 and Comparative Examples 1 to 7) were subjected to a cutting test under the following conditions.

<Chipping-Resistance Test>

The test was conducted under such conditions that SCM440 (with 6 grooves) was employed as the work material, a cutting speed was set to 150 m/min., a feed rate was set to 0.2 mm/rev., a depth of cut was set to 1.5 mm, and a dry test was adopted. Regarding evaluation, a ratio of breakage was calculated based on the number of breakages (the number of broken cutting edges) after 20 cutting edges were used for cutting for 20 seconds. Namely, a ratio of breakage (%) = (the number of breakages/20) x 100. The results are shown in Table 2. An insert lower in the ratio of breakage indicates excellent chipping resistance. As can clearly be seen from Table 2, it was confirmed that the indexable inserts in Examples achieved significant improvement in chipping resistance, as compared with the indexable inserts in Comparative Examples.

<Critical Feed Rate Test>

The test was conducted under such conditions that S45C was employed as the work material, a cutting speed was set to 200 m/min., a depth of cut was set to 1.8 mm, and a dry test was adopted. A feed rate was increased from 0.2 mm/rev. by 0.01 mm/rev., and the feed rate at the time when the cutting edge broke was determined as the critical feed rate amount. The results are shown in Table 2. A greater numeric value of the critical feed rate amount indicates higher cutting efficiency As can clearly be seen from Table 2, it was confirmed that the indexable inserts in Examples achieved significant improvement in the critical feed rate amount and can adapt to high-efficiency working, as compared with the indexable inserts in Comparative Examples.

<Wear-Resistance Test>

The test was conducted under such conditions that SCr420H was employed as the work material, a cutting speed was set to 300 m/min., a feed rate was set to 0.2 mm/rev., a depth of cut was set to 2.0 mm, and a wet test (water-soluble cutting oil) was adopted. Regarding evaluation, an average wear amount Vb (mm) on the insert flank face side after cutting for 15 minutes was measured (a smaller numeric value thereof indicates excellent wear resistance). In addition, an outer diameter of the work material was measured and working accuracy with respect to a set value was measured (a smaller absolute value thereof indicates excellent working accuracy). In addition, damage in the indexable insert after the cutting test was observed with a scanning electron microscope (SEM) (in Table 2, $Al_2O_3$ represents the alumina layer). In addition, clearness of the corner of the indexable insert after the cutting test was visually inspected.

The results are shown in Table 2.

As can clearly be seen from Table 2, it was also confirmed that the indexable inserts in Examples achieved significant improvement in wear resistance and very high working accuracy, as compared with the indexable inserts in Comparative Examples. In addition, as a result of observation with the SEM, it could be confirmed that the indexable inserts in Examples were satisfactory also in terms of damage in the insert and achieved long life in a stable manner and good adhesiveness between the substrate and the coating layer, as compared with the indexable inserts in Comparative Examples. Moreover, it could also be confirmed that the used corner was very clearly identified in particular when a layer composed of TiN was formed as the outermost layer.

As described above, it could be confirmed that the indexable insert according to the present invention achieved both of wear resistance and chipping resistance as well as excellent adhesiveness between the substrate and the coating layer.

Table 2

| | Ratio of Breakage (%) | Critical Feed Rate Amount (mm/rev) | Average Wear Amount Vb (mm) | Working Accuracy of Work Material (mm) | Damage Observed with SEM | Visual Inspection of Corner Clearness |
|---|---|---|---|---|---|---|
| Example 1 | 0 | 0.71 | 0.048 | -0.007 | Normal wear | Very clear |
| Example 2 | 5 | 0.73 | 0.042 | -0.005 | Normal wear | Very clear |
| Example 3 | 0 | 0.69 | 0.045 | -0.005 | Normal wear | Very clear |
| Example 4 | 10 | 0.67 | 0.052 | -0.009 | Normal wear (Slight peel-off of $Al_2O_3$) | Very clear |
| Example 5 | 15 | 0.68 | 0.056 | -0.009 | Normal wear (Wear of $Al_2O_3$ to some extent) | Very clear |
| Example 6 | 10 | 0.65 | 0.051 | -0.008 | Normal wear (Slight chipping, adhesion of $Al_2O_3$) | Very clear |
| Example 7 | 10 | 0.66 | 0.052 | -0.009 | Normal wear (Slight chipping of TiCN layer) | Very clear |
| Example 8 | 15 | 0.66 | 0.056 | -0.008 | Normal wear (Slight chipping of TiCN layer) | Very clear |
| Example 9 | 20 | 0.62 | 0.063 | -0.012 | Normal wear (Slight chipping, adhesion of TiCN layer) | Very clear |
| Example 10 | 25 | 0.63 | 0.062 | -0.01 | Normal wear (Crater wear to some extent) | Very clear |

(continued)

| | Ratio of Breakage (%) | Critical Feed Rate Amount (mm/rev) | Average Wear Amount Vb (mm) | Working Accuracy of Work Material (mm) | Damage Observed with SEM | Visual Inspection of Corner Clearness |
|---|---|---|---|---|---|---|
| Example 11 | 20 | 0.63 | 0.067 | -0.013 | Normal wear (Slight chipping) | Very clear |
| Example 12 | 25 | 0.61 | 0.061 | -0.012 | Normal wear (Slight chipping, peel-off) | Very clear |
| Example 13 | 25 | 0.63 | 0.063 | -0.012 | Normal wear | Unclear to some extent |
| Example 14 | 30 | 0.62 | 0.065 | -0.011 | Normal wear | Unclear to some extent |
| Example 15 | 20 | 0.61 | 0.062 | -0.01 | Normal wear (Slight chipping of $Al_2O_3$) | Very clear |
| Example 16 | 20 | 0.58 | 0.062 | -0.011 | Normal wear (Slight peel-off of $Al_2O_3$) | Very clear |
| Example 17 | 30 | 0.61 | 0.063 | -0.012 | Normal wear (Slight peel-off of $Al_2O_3$) | Very clear |
| Example 18 | 25 | 0.59 | 0.067 | -0.011 | Normal wear (Slight peel-off of $Al_2O_3$) | Very clear |
| Example 19 | 25 | 0.58 | 0.064 | -0.012 | Normal wear (Peel-off of outermost layer to some extent) | Very clear |
| Example 20 | 30 | 0.63 | 0.061 | -0.01 | Normal wear (Slight chipping of $Al_2O_3$) | Very clear |
| Example 21 | 35 | 0.55 | 0.072 | -0.015 | Normal wear (Peel-off, adhesion to some extent) | Very clear |
| Example 22 | 20 | 0.62 | 0.068 | -0.012 | Normal wear (Chipping, peel-off to some extent) | Very clear |
| Example 23 | 35 | 0.56 | 0.073 | -0.014 | Normal wear (Chipping, peel-off to some extent) | Very clear |

(continued)

| | Ratio of Breakage (%) | Critical Feed Rate Amount (mm/rev) | Average Wear Amount Vb (mm) | Working Accuracy of Work Material (mm) | Damage Observed with SEM | Visual Inspection of Corner Clearness |
|---|---|---|---|---|---|---|
| Example 24 | 45 | 0.49 | 0.081 | -0.018 | Normal wear (Chipping, peel-off, adhesion to some extent) | Unclear to some extent |
| Example 25 | 40 | 0.53 | 0.078 | -0.016 | Normal wear (Chipping, peel-off, adhesion to some extent) | Unclear to some extent |
| Comparative Example 1 | 95 | 0.25 | 0.514 | -0.147 | Breakage and/or chipping | Determination cannot be made because of breakage |
| Comparative Example 2 | 85 | 0.27 | 0.475 | -0.102 | Breakage and/or chipping of TiCN layer Breakage and/or chipping of TiCN layer | Determination cannot be made because of great wear cannot be made because of great wear |
| Comparative Example 3 | 95 | 0.25 | 0.542 | -0.162 | Breakage | Determination cannot be made because of breakage |
| Comparative Example 4 | 90 | 0.26 | 0.495 | -0.125 | Adhesion, breakage and/or film peel-off | Determination cannot be made because of breakage |
| Comparative Example 5 | 70 | 0.35 | 0.295 | -0.086 | Breakage and/or film peel-off | Determination cannot be made because of breakage |
| Comparative Example 6 | 95 | 0.25 | 0.536 | -0.153 | Breakage | Determination cannot be made because of breakage |
| Comparative Example 7 | 100 | 0.23 | 0.583 | -0.182 | Breakage at initial stage | Determination cannot be made because of breakage |

Though the embodiments and the examples of the present invention have been described above, combination of embodiments and examples described above as appropriate is originally intended.

It should be understood that the embodiments and the examples disclosed herein are illustrative and non-restrictive in every respect. The scope of the present invention is defined by the terms of the claims, rather than the description above, and is intended to include any modifications within the scope and meaning equivalent to the terms of the claims.

**Claims**

1. An indexable insert, comprising:

    a substrate; and
    a coating layer formed on the substrate,
    said coating layer being formed of a plurality of layers including at least a TiCN layer, and at least one layer among the plurality of layers being provided with compressive residual stress, and
    said TiCN layer being a layer mainly composed of TiCN and having highest peak intensity in a (422) plane and second peak intensity in a (311) plane in X-ray diffraction, and a ratio of peak intensity I(422)/I(311) between peak intensity I(422) of the (422) plane and peak intensity I(311) of the (311) plane being not lower than 1.1 and not higher than 10.

2. The indexable insert according to claim 1, wherein
    said TiCN layer has an orientation index TC(220) of a (220) plane, not greater than 1.

3. The indexable insert according to claim 1, wherein
    said coating layer includes an outermost layer and an alumina layer in addition to said TiCN layer,
    said outermost layer is a layer forming a surface of said coating layer, mainly composed of any of a carbide, a nitride and a carbonitride of Ti,
    said alumina layer is a layer mainly composed of $Al_2O_3$, located between said outermost layer and said TiCN layer, and at least one of said outermost layer, said alumina layer and said TiCN layer is provided with compressive residual stress not smaller than 0.05 GPa and not greater than 2 GPa.

4. The indexable insert according to claim 3, wherein
    said outermost layer is composed of a nitride of Ti.

5. The indexable insert according to claim 3, wherein
    said alumina layer is a layer mainly composed of $Al_2O_3$ having a $\kappa$-type crystal structure.

6. The indexable insert according to claim 3, wherein
    said coating layer includes a TiBN layer composed of $TiB_xN_y$ (where x and y each represent an atomic ratio and relation of $0.001 \leq x/(x+y) \leq 0.04$ is satisfied) directly under said alumina layer.

7. The indexable insert according to claim 3, wherein
    said outermost layer has a thickness not smaller than 0.05 $\mu$m and not greater than 1 $\mu$m.

8. The indexable insert according to claim 3, wherein
    said alumina layer has a thickness not smaller than 0.05 $\mu$m and not greater than 2 $\mu$m.

9. The indexable insert according to claim 1, wherein
    said coating layer further includes one or more hard layer formed of a compound composed of at least one element selected from the group consisting of IVa-group elements, Va-group elements and VIa-group elements in a periodic table, Al, and Si and at least one element selected from the group consisting of carbon, nitrogen, oxygen, and boron.

10. The indexable insert according to claim 1, wherein
    said coating layer is formed with a chemical vapor deposition method.

11. The indexable insert according to claim 1, wherein
    said coating layer includes a lowermost layer composed of a nitride of Ti and having a thickness not smaller than 0.05 $\mu$m and not greater than 1 $\mu$m.

12. The indexable insert according to claim 1, wherein
    said substrate is formed from any of cemented carbide, cermet, high-speed steel, ceramics, sintered cubic boron nitride, sintered diamond, and sintered silicon nitride.

## INTERNATIONAL SEARCH REPORT

| | International application No. |
|---|---|
| | PCT/JP2008/068277 |

A.  CLASSIFICATION OF SUBJECT MATTER
*B23B27/14*(2006.01)i, *B23B51/00*(2006.01)i, *B23C5/16*(2006.01)i, *C23C16/30*(2006.01)i

According to International Patent Classification (IPC) or to both national classification and IPC

B.  FIELDS SEARCHED

Minimum documentation searched (classification system followed by classification symbols)
B23B27/14, B23B51/00, B23C5/16, C23C16/30, B23P15/28

Documentation searched other than minimum documentation to the extent that such documents are included in the fields searched
Jitsuyo Shinan Koho          1922-1996   Jitsuyo Shinan Toroku Koho   1996-2008
Kokai Jitsuyo Shinan Koho    1971-2008   Toroku Jitsuyo Shinan Koho   1994-2008

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| Y | JP 2007-253316 A  (Sumitomo Electric Hardmetal Corp.), 04 October, 2007 (04.10.07), Par. Nos. [0086] to [0109]; tables 1, 3 (Family: none) | 1-12 |
| Y | JP 11-256336 A  (Hitachi Metals, Ltd.), 21 September, 1999 (21.09.99), Par. Nos. [0010], [0015] to [0017], [0040] to [0045]; tables 1 to 2, 5, 7 (Family: none) | 1-12 |
| Y | JP 2000-158209 A  (Hitachi Metals, Ltd.), 13 June, 2000 (13.06.00), Par. Nos. [0016] to [0027]; tables 1 to 3; Fig. 1 (Family: none) | 1-12 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 04 November, 2008 (04.11.08) | 18 November, 2008 (18.11.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.

PCT/JP2008/068277

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2007-181896 A  (Sumitomo Electric Hardmetal Corp.), 19 July, 2007 (19.07.07), Par. Nos. [0077] to [0079]; table 1 & WO 2007/077822 A1 | 1-12 |
| A | JP 11-131235 A  (Sumitomo Electric Industries, Ltd.), 18 May, 1999 (18.05.99), Par. Nos. [0033] to [0039]; tables 1 to 2 (Family: none) | 1-12 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 7100701 A
- JP 11256336 A
- JP 4300104 A
- JP 64031972 B

**Non-patent literature cited in the description**

- X-ray Stress Measurement. The Society of Materials Science. Yokendo Co., Ltd, 1981, 54-67